# FASCICULE DE BREVET EUROPEEN

(11) **EP 3 255 806 B1**
(45) Date de publication et mention de la délivrance du brevet: **29.07.2020**
(21) Numéro de dépôt: 17174054.1
(22) Date de dépôt: 01.06.2017
(51) Int. Cl.: H04B 3/23, H04B 1/525, H03H 7/20, H03H 7/25, H03H 7/32, H04B 1/10, H04B 1/12

(54) **CIRCUIT A RETARD POUR LE DÉCALAGE TEMPOREL D'UN SIGNAL RADIOFRÉQUENCE ET DISPOSITIF DE RÉDUCTION D'INTERFÉRENCES UTILISANT LEDIT CIRCUIT**
VERZÖGERUNGSSCHALTKREIS FÜR DIE ZEITLICHE VERZÖGERUNG EINES FUNKFREQUENZSIGNALS, UND VORRICHTUNG ZUR INTERFERENZREDUZIERUNG, DIE EINEN SOLCHEN SCHALTKREIS NUTZT
DELAY CIRCUIT FOR THE TIME DELAY OF A RADIO-FREQUENCY SIGNAL AND DEVICE FOR REDUCING INTERFERENCES USING SAID CIRCUIT

(30) Priorité: 06.06.2016 FR 1655129
(43) Date de publication de la demande: 13.12.2017
(73) Titulaire: Airbus DS SLC, 78990 Elancourt (FR)
(72) Inventeur: GAGEY, Olivier, 75006 Paris (FR)
(74) Mandataire: Cabinet Camus Lebkiri

(56) Documents cités:
- DE-A1- 3 401 994
- US-A- 4 885 562
- US-A1- 2004 146 237
- US-A1- 2009 061 808
- US-A1- 2015 130 558

## Description

### DOMAINE

Le domaine de l'invention concerne les systèmes d'émission et réception d'ondes de radiocommunication. L'invention porte en particulier sur le traitement des interférences entre différentes systèmes de communication radio disposés à faible distance, comme par exemple des systèmes de communication radio installés dans un même véhicule et ayant leurs antennes radio sur le toit du dit véhicule..

### ETAT DE L'ART

Les services de secours ou de sécurité sont amenés à utiliser différents équipements de radiocommunication pour répondre à leur multiple besoins en matière de communication. Un véhicule peut ainsi être équipé d'un terminal tel qu'un terminal LTE présentant des canaux de communication radio ayant une large bande de fréquence et un haut débit ainsi que d'un terminal tel qu'un terminal TETRAPOL présentant des canaux de communication radio ayant une bande de fréquence étroite et un faible débit. Les antennes d'émission et de réception des terminaux respectifs, placées par exemple sur le toit d'un véhicule, peuvent alors exercer une action parasitaire l'une sur l'autre.

Les systèmes de communication à faible débit utilisés sont par exemple, du type Tetrapol, Tetra ou P25.

Les systèmes de communication à haut débit utilisés sont par exemple, du type 4G ou LTE.

Deux systèmes de communication radio peuvent ainsi interférer, ce qui dégrade la qualité des communications et peut même rendre les communications impossibles.

Des interférences ont naturellement lieu même si l'émission et la réception sont effectuées sur deux bandes fréquentielles différentes. En effet, le signal émis contient un bruit large bande, ce type de bruit étant amplifié par les non-linéarités de la chaîne de transmission. Le bruit large bande et la bande fréquentielle de l'équipement récepteur se chevauchent alors sur toute la largeur de la bande ou partiellement, ce qui dégrade la qualité de la réception. De même, la présence d'un signal radio émis à forte puissance à faible distance d'un récepteur peut désensibiliser le dit récepteur, même si les bandes fréquentielles d'émission et de réception sont différentes.

On connait le document US-2009/0061808 qui décrit un système et un procédé adaptatif d'annulation d'un signal radiofréquence. Ce type de système est toutefois spécifiquement réglé pour un brouilleur EMI (electro-magnetic interference) implanté à demeure sur un aéronef équipé par ailleurs d'une antenne de communication radiofréquence. De même, le document US2009/0227213 décrit un système d'annulation d'interférence entre l'émetteur et le récepteur d'un système RFID. Ce système d'annulation d'interférence comprend un dispositif pour prélever une partie du signal émis. Cette partie du signal émis, appelée également « signal de référence », est envoyé à un circuit de compensation. Ce circuit de compensation modifie la phase et l'amplitude du signal de référence. Un dispositif permet d'injecter ce signal de référence modifié en phase et en amplitude dans le signal reçu par le récepteur. Le signal de référence ainsi modifié en phase et amplitude et injecté dans le signal reçu par le récepteur s'appelle également « signal de compensation ». Le récepteur reçoit la somme du signal émis par l'émetteur et présent au niveau de l'antenne du récepteur, également appelé « signal direct », et le signal de compensation. En ajustant l'amplitude du signal de compensation au niveau de l'amplitude du signal direct et en déphasant de 180° (modulo 360°) la phase du signal de compensation par rapport à la phase du signal direct, le signal de compensation annule le signal direct. Une différence des délais temporels entre le signal direct et le signal émis par l'émetteur et entre le signal de compensation et le signal émis par l'émetteur dégrade fortement les performances de ce type de dispositif. L'annulation du signal direct par le signal de compensation n'intervient alors que dans une plage fréquentielle réduite, rendant le dispositif inefficace pour annuler le bruit large bande émis par l'émetteur ou bien pour annuler dans tout le canal d'émission le signal émis d'un signal de communication à haut débit. Ainsi, si avec ce dispositif, le signal de compensation est parfaitement réglé en amplitude et phase par rapport au signal direct à une fréquence centrale, à 50 MHz de cette fréquence centrale une différence d'environ 0.2 ns de délai temporel entre le signal direct et le signal émis par l'émetteur et entre le signal de compensation et le signal émis par l'émetteur limitera la réjection du signal direct à environ 30 dB. On peut noter que cette limitation de réjection à environ 30 dB est aussi atteinte pour une différence d'amplitude entre le signal de compensation et le signal direct d'environ 0.27 dB, la phase et le délai étant parfaitement ajustés par ailleurs. L'homme du métier connaît par ailleurs l'utilisation de filtres passe bande tels que des filtres à cavités utilisés pour l'émission et pour la réception. Ces filtres représentent cependant un coût important et leurs bandes de fréquences passantes et de réjections sont difficilement modifiables en mode opérationnel. L'homme du métier connaît également des circuits à retard tels que ceux décrits dans les documents US 4885562, DE 3401994 ou US 2004/146237. Toutefois, ces circuits à retard ne sont pas adaptés à une utilisation dans des systèmes d'atténuation des interférences, du fait qu'ils ne permettent pas de régler précisément certaines propriétés du décalage temporel qu'ils introduisent.

Il apparaît ainsi le besoin pour l'homme du métier d'améliorer les systèmes d'atténuation des interférences.

### RESUME DE L'INVENTION

Pour résoudre ces problèmes, un objet de l'invention concerne un circuit à retard pour le décalage temporel d'un signal radiofréquence d'entrée. Ledit circuit à retard comprend un filtre passe tout ayant une fréquence centrale donnée configuré pour linéariser le déphasage du signal de sortie par rapport au signal d'entrée en fonction de la fréquence sur une première gamme fréquentielle et caractérisé en ce qu'il comprend un premier circuit anti-résonant ayant une première fréquence centrale et un deuxième circuit anti-résonant ayant une deuxième fréquence centrale, le filtre passe tout et les deux circuits anti-résonants étant configurés et agencés pour linéariser le déphasage du signal en sortie par rapport au signal d'entrée en fonction de la fréquence sur une seconde gamme fréquentielle incluant la première gamme. L'écart entre la première et la deuxième fréquence centrale étant inférieure à 30% de la valeur d'une des deux fréquences centrales. L'écart entre la première fréquence centrale et la fréquence centrale donnée du circuit passe tout étant inférieur à 30% de la valeur de la fréquence la plus élevée entre la première fréquence centrale et la fréquence centrale donnée.

A cet effet, la présente invention décrit notamment un dispositif d'élimination physique des interférences qui permet d'ajuster à la fois le déphasage, l'amplitude et le décalage temporel du signal de compensation. La possibilité d'ajuster le décalage temporel en plus de la phase et de l'amplitude du signal de compensation permet d'éliminer efficacement les interférences sur une large bande de fréquences. A cette fin l'invention concerne également un circuit à retard capable de fournir un délai sensiblement constant sur une plage de fréquences élargie par rapport aux circuits à retard connus. De plus, le circuit à retard décrit par la présente invention montre une stabilité du retard en fonction de la fréquence améliorée par rapport aux circuits à retard connus de l'homme du métier. Un tel circuit à retard amélioré est donc une brique fondamentale de la présente invention.

On entend par circuit à retard un circuit capable de fournir en sortie un signal Vout identique au signal en entrée Vin mais avec un décalage temporel.

On entend par filtre passe tout un circuit à retard connu par l'homme du métier, par exemple un circuit comprenant un circuit bouchon et un circuit résonnant.

On entend par fréquence centrale d'un circuit passe tout la fréquence au milieu de la bande de fréquences sur laquelle le décalage temporel entre le signal à l'entrée du filtre et le signal à la sortie du filtre est le plus élevée.

On entend par circuit anti-résonant un circuit ayant une impédance élevée autour de sa fréquence centrale et une impédance faible loin de sa fréquence centrale.

On entend par fréquence centrale d'un circuit anti-résonant la fréquence au milieu de la bande de fréquences sur laquelle l'impédance du circuit est élevée.

Même si le filtre passe tout constitue en soi un circuit à retard, ce type de circuit comporte des inconvénients : le décalage temporel introduit n'est pas constant en fonction de la fréquence du signal transmis. Autrement dit, la courbe illustrant la relation entre décalage temporel introduit et fréquence du signal n'est pas plate sur la plage de fréquence d'intérêt.

Cette caractéristique limite l'utilisation d'un circuit passe tout dans un dispositif de suppression physique des interférences entre deux systèmes de communication radio lorsque une suppression large bande des interférences est recherchée.

La variation du décalage temporel avec la fréquence vient du fait que le déphasage du signal en sortie Vout est linéaire en fonction de la fréquence seulement sur une petite plage de fréquence autour de la fréquence centrale du circuit passe tout.

En revanche l'introduction des deux circuits anti-résonants permet de mieux contrôler la linéarité du déphasage du signal en sortie Vout en fonction de la fréquence. Notamment la plage de linéarité entre le déphasage introduit et la fréquence est plus grande grâce à la présence des deux filtres anti-résonants.

Afin de réduire les interférences sur un récepteur, l'invention permet d'intégrer un circuit à retard amélioré dans un dispositif d'élimination physique des interférences pour des systèmes de communication radio.

A cet, effet, un autre objet de l'invention concerne un dispositif de réduction d'interférences entre un premier équipement radio comportant au moins un émetteur et un deuxième équipement radio comportant au moins un récepteur, caractérisé en ce que ledit dispositif comprend :
- Un premier coupleur configuré pour prélever une partie du signal émis par le premier équipement radio ;
- Un circuit de traitement de la partie de signal prélevé délivrant un signal modifié, ledit circuit de traitement comportant un composant à délai variable comprenant au moins un circuit à retard, introduisant un décalage temporel du signal prélevé ;
- Un second coupleur configuré pour sommer le signal modifié au signal reçu par le deuxième équipement.

On entend par signal reçu par le deuxième équipement, le signal émis par l'émetteur et présent au niveau de l'antenne du récepteur du deuxième équipement.

On entend par dispositif de réduction d'interférences un dispositif qui vise à réduire les perturbations entre les deux équipements. Par exemple un dispositif qui vise l'atténuation du signal émis par le premier équipement dans le signal reçu par le deuxième équipement.

Dans la suite on appellera un tel dispositif d'interférences indifféremment un dispositif d'élimination d'interférences ou un dispositif d'élimination d'interférences entre un premier équipement et un deuxième équipement.

Le signal de compensation est ajouté au signal reçu par le deuxième équipement pour effacer le signal émis par le premier équipement. Pour ce faire, l'amplitude du signal de compensation est ajustée au niveau de l'amplitude du signal reçu, le délai du signal de compensation avec le signal émis est ajusté pour être au plus proche du délai entre le signal reçu et le signal émis, la phase du signal de compensation est ajustée pour être à 180° (modulo 360°) de la phase du signal reçu.

On entend par circuit de traitement de la partie de signal prélevé le circuit de compensation. Le circuit de traitement ou circuit de compensation comporte un circuit à retard selon l'invention. Cela permet de contrôler très précisément le décalage temporel du signal sur une plage agrandie de fréquences.

Ce dispositif est donc particulièrement adapté à la correction des interférences sur une large plage de fréquences.

Le dispositif d'élimination d'interférences selon l'invention peut également présenter une ou plusieurs des caractéristiques ci-dessous, considérées individuellement ou selon toutes les combinaisons techniquement possibles :
- le filtre passe tout est un circuit comprenant au moins un circuit bouchon formé par une première inductance associée en parallèle avec un premier condensateur, un deuxième condensateur, un troisième condensateur et un quatrième condensateur, ledit circuit bouchon possédant une fréquence de coupure fa, le filtre passe tout comprenant en outre un circuit résonnant formé par un cinquième condensateur associé en série avec une deuxième inductance, ledit circuit résonnant possédant une fréquence de résonnance fb, les fréquence de coupure fa et la fréquence de résonnance fb ayant un écart inférieur à 20% de la valeur de l'une des deux fréquences.
- les circuits anti-résonants comprennent chacun un condensateur associé en parallèle avec une inductance ;
- le circuit de traitement comprend un déphaseur variable modifiant la phase du signal prélevé par le premier coupleur et un gain variable modifiant l'amplitude du signal prélevé par le premier coupleur ;
- le dispositif d'élimination des interférences comprend un composant à délai variable comportant :
   ∘ un premier circuit comportant au moins un circuit à retard selon l'invention introduisant un délai fixe ;
   ∘ un second circuit agencé en série du premier circuit comportant au moins une ligne à retard selon l'invention introduisant un premier délai paramétrable par palier et ;
   ∘ un troisième circuit agencé en série des premier et second circuits introduisant un second délai paramétrable de façon continu ;
- le dispositif d'élimination des interférences comprend :
   ∘ Un coupleur configuré pour prélever une partie du signal somme et transmettre le reste du signal somme au deuxième équipement; On entend par signal somme le signal reçu par le deuxième équipement et le signal de compensation.
   ∘ Un équipement de caractérisation du signal somme ;
   ∘ Un équipement de contrôle configuré pour recevoir le signal issu de l'équipement de caractérisation du signal somme et pour contrôler les équipements de modification des propriétés du signal prélevé ;
- le premier équipement radio et le deuxième équipement radio sont le même équipement ;
- l'antenne émission du premier équipement radio est commune avec l'antenne réception du deuxième équipement radio ;
- le circuit à retard est entre le coupleur de prélèvement du premier équipement radio et son antenne émission et/ou le circuit à retard est entre l'antenne réception du deuxième équipement radio et le coupleur d'injection du signal de compensation ;
- les coupleurs sont des coupleurs radiofréquence ou des diviseurs de puissance asymétrique
- l'équipement de contrôle contient une mémoire pour l'enregistrement des paramètres du déphaseur, du gain variable et du délai.
- Une séquence d'apprentissage avec un signal émis large bande permet d'ajuster les paramètres du déphaseur, du gain variable et du délai à des valeurs par défauts. Ces valeurs pourront être utilisées par l'équipement de contrôle comme point de départ des réglages du déphaseur, du gain variable et du délai pour les prochaines émissions opérationnelles de l'émetteur.

L'invention a également pour objet une ligne à retard pour l'introduction d'un retard variable dans un signal de sortie, ladite ligne de retard comprenant un montage en cascade d'une pluralité de circuits à retard selon l'invention, chaque circuit à retard :
- introduisant un multiple donné d'un retard de base (T_{base}) et ;
- étant associé à un commutateur (RF switch) pour activer ou désactiver le circuit à retard,

un composant de paramétrage du retard étant configuré pour introduire un retard donné par activation/désactivation d'un sous ensemble des commutateurs de la ligne à retard.

### LISTE DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- La figure 1 illustre le circuit à retard selon l'invention ;
- La figure 2a illustre un filtre passe tout, utilisé comme circuit à retard dans l'art antérieur ;
- La figure 2b montre la transmission et le retard temporel introduit par le circuit de figure 2a sur une gamme de fréquence allant de 300 MHz à 460 MHz ;
- La figure 3a illustre un exemple de réalisation du circuit à retard selon l'invention ;
- La figure 3b montre la transmission et le retard temporel introduit par le circuit de figure 3a sur une gamme de fréquence allant de 300 MHz à 460 MHz;
- La figure 4 montre une ligne à retard obtenue en combinant plusieurs circuits à retard et plusieurs commutateurs radiofréquence ;
- La figure 5 illustre le circuit pour l'élimination des interférences ;
- La figure 6a montre le signal reçu par un équipement récepteur avec et sans l'élimination des interférences à l'aide du dispositif d'élimination des interférences selon l'invention et une différence de 1 ns de délai entre le signal reçu et le signal de compensation.
- La figure 6b montre le signal reçu par un équipement récepteur avec et sans l'élimination des interférences à l'aide du dispositif d'élimination des interférences selon l'invention, et une différence de 15 ns de délai entre le signal reçu et le signal de compensation.
- La figure 7 montre un exemple de réalisation de déphaseur variable.
- La figure 8 montre un exemple de réalisation d'un atténuateur variable ou gain variable avec gain négatif.

### DESCRIPTION DETAILLEE

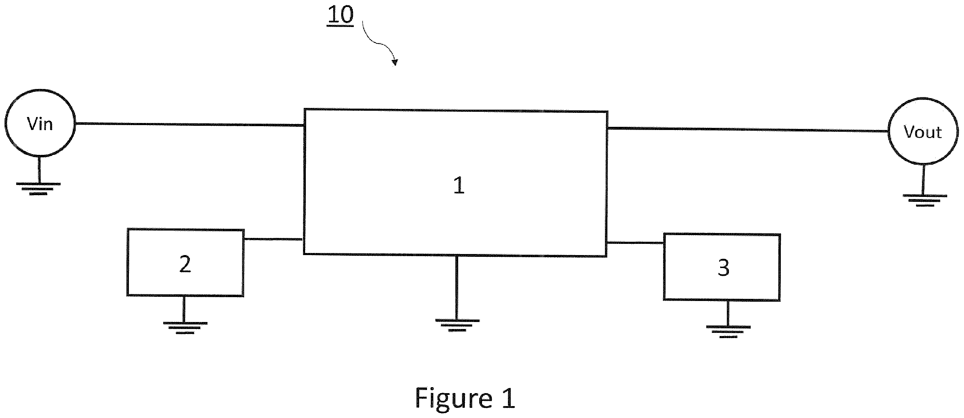

La figure 1 illustre le circuit à retard 10 selon l'invention. Le circuit 10 est un circuit capable de fournir en sortie un signal Vout identique au signal Vin mais avec un décalage temporel.

Le circuit à retard 10 selon l'invention est composé par un filtre passe tout 1 et par deux circuits anti-résonants 2,3. Le filtre passe tout 1 a une fréquence centrale donnée f₀. Les premier et deuxième circuits anti-résonants 2 et 3 ont les fréquences centrales respectivement f₁ et f₂

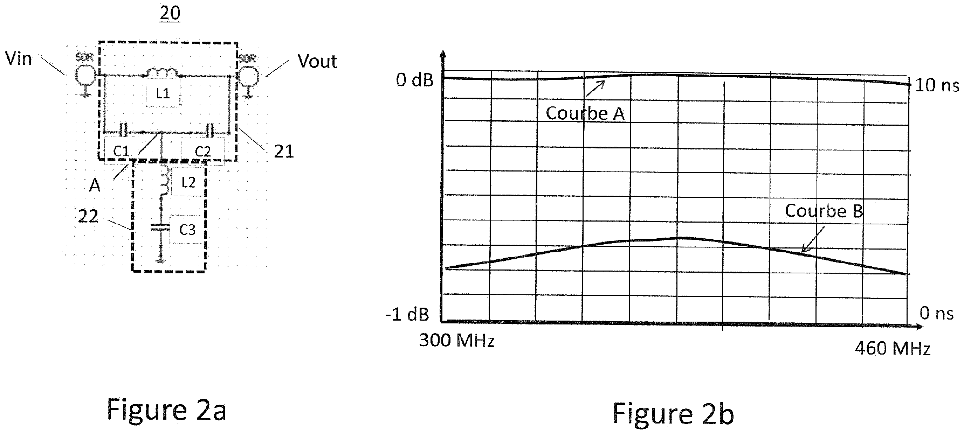

Un exemple 20 de circuit passe tout connu de l'homme du métier est représenté figure 2a. Ce circuit comprend un circuit bouchon 21 et un circuit résonnant 22. La figure 2b montre les caractéristiques de ce filtre sur la plage de fréquences comprise entre 300 MHz et 460 MHz.

Une façon de comprendre qualitativement le fonctionnement du circuit 20 est la suivante. Le circuit bouchon 21 formé par les capacités C1 et C2 associées en parallèle avec une inductance (appelée également self) L1 possède une fréquence de coupure fa. Le circuit résonnant 22 formé par la capacité C3 associé en série avec la self L2 possède une fréquence de résonnance fb. Les valeurs des composants C1, C2, L1, C3, L2 sont ajustées pour avoir les fréquences fa et fb quasi identiques. On entend par fa et fb quasi identiques un écart inférieur à 20% entre les deux fréquences.

Loin des fréquences fa et fb, l'impédance du circuit résonnant 22 est élevée. Le circuit 20 se comporte comme un circuit bouchon loin de se fréquence de coupure : la transmission du signal à travers ce filtre est très faiblement atténuée avec un retard de transmission faible. Proche des fréquences fa et fb, l'impédance du circuit résonnant 22 est faible, le point A du circuit 20 se retrouve connecté électriquement à la masse, le circuit 20 peut être assimilé à une ligne en retard formée d'une self en série L1 et de deux capacités C1 et C2 connectées à chaque extrémité de la self L1 et à la masse, cette ligne à retard présente un maximum de retard à la fréquence fa.

La figure 2b résume les performances du circuit 20 avec pour valeur de composants : C1 = C2 = 15pF, L1 = 22 nH, C3 = 10 pF, L2 = 22 nH. Les valeurs de composants ne sont données qu'à titre illustratif et d'autres valeurs sont possibles.

La courbe A de la figure 2b montre la transmission en fonction de la fréquence du signal transmis. On entend par transmission l'amplitude du signal en sortie Vout à une fréquence donnée divisée par l'amplitude du signal en entrée Vin à la même fréquence. La transmission varie très légèrement en fonction de la fréquence sur la plage de fréquences considérées, ce qui explique le nom de circuit passe tout.

La courbe B de la figure 2b représente le délai introduit par le circuit 20 en fonction de la fréquence du signal. Le délai introduit est d'environ 3.3 ns au milieu de la plage de fréquences. A 50 MHz de part et autre de la fréquence centrale du filtre passe tout, la variation de délai par rapport au délai à la fréquence centrale peut atteindre 0.7 ns, tandis que la variation de transmission par rapport à la transmission à la fréquence centrale n'atteint que 0.02 dB. Le compromis entre la stabilité en fonction de la fréquence de l'atténuation et la stabilité en fonction de la fréquence du délai est ainsi très déséquilibré, ce type de structure présentant une excellente stabilité de l'amplitude en fonction de la fréquence et une médiocre stabilité du délai en fonction de la fréquence. La plage de fréquences B1 pour laquelle le déphasage est linéaire ou quasi linéaire en fonction de la fréquence, c'est-à-dire le délai est constant ou quasi constant, est très limitée.

Ces variations du délai sur la plage de fréquences d'intérêt ne permettent pas d'ajuster correctement le décalage temporel du signal de compensation dans un dispositif d'élimination physique des interférences large bande.

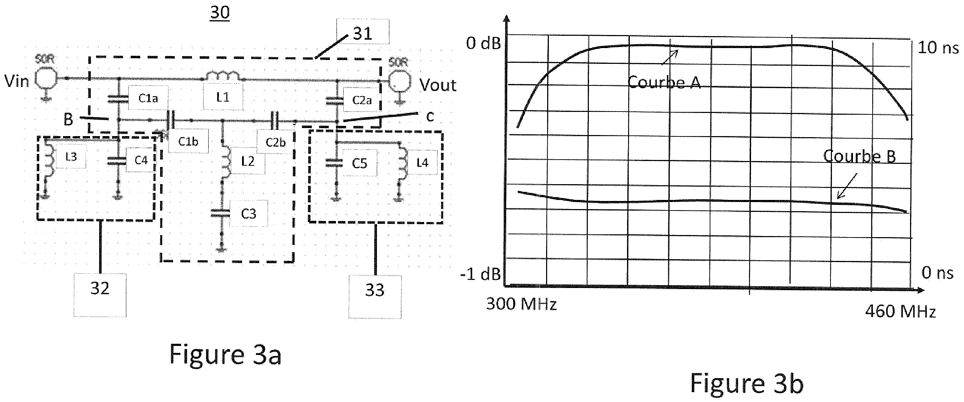

Un exemple de réalisation de circuit à retard selon l'invention est le circuit 30 de figure 3a.

Le circuit 30 de figure 3a est un filtre passe tout 31 associé à deux circuits anti-résonants 32, 33 ayant fréquences centrales f₁ et f₂. Les deux circuits anti-résonnants sont intégrés au filtre passe tout par deux connexions électriques.

Selon un mode de réalisation, le premier circuit anti-résonnant 32 comprend un condensateur C4 associé en parallèle avec une self L3.

Selon un mode de réalisation, le deuxième circuit anti-résonnant 33 comprend un condensateur C5 associé en parallèle avec une self L4.

Selon un mode de réalisation, un premier couple de condensateurs C1a, C1b comportant un premier condensateur C1a et un second condensateur C1b est représenté sur le circuit passe tout. Un premier circuit anti-résonnant 32 est connecté entre le premier C1a et le second condensateur C1b. Un second couple de condensateurs C2a, C2b comportant un troisième condensateur C2a et un quatrième condensateur C2b est représenté sur le circuit passe tout 31. Le second circuit anti-résonnant 33 est connecté entre le troisième C2a et le quatrième condensateur C2b.

Dans cet exemple, le premier condensateur C1a et le troisième condensateur C2a ont une capacité de 27pF, le deuxième condensateur C1b et le quatrième condensateur C2b ont une capacité de 36pF.

Le premier C1a, C1b et deuxième C2a, C2b couple de condensateurs de la figure 3a fournissent deux capacités équivalentes ou quasi équivalentes aux capacités fournies par le premier C1 et deuxième condensateur C2 de figure 2a.

Quand les fréquences f₁ et f₂ sont opportunément choisies par rapport à la fréquence centrale du filtre passe tout 31 la plage de fréquences B2 pour lesquelles le déphasage est linéaire ou quasi linéaire en fonction de la fréquence est plus étendue que la plage B1. Pour ce faire, les fréquences f1 et f2 sont ajustées pour créer un deuxième maximum dans la courbe représentant le délai entre l'entrée et la sortie du circuit 30. Ce deuxième maximum va permettre de stabiliser la variation du délai en fonction de la fréquence du circuit 30.

Une façon de comprendre qualitativement le fonctionnement du circuit 30 est la suivante. Les composants C1a, C1b, C2a, C2b, L1, L2, C3 du filtre passe tout 31 sont ajustés pour régler le filtre passe tout tel que décrit précédemment. Les composants des circuits anti-résonnants 32 et 33 sont ajustés pour avoir des fréquences d'anti résonnance f₁ et f₂ proche de la fréquence centrale f₀ du filtre passe tout 31. Loin de cette fréquence centrale f₀ du filtre passe tout 31, les circuits anti-résonnant présentent une impédance faible, les points B et C du circuit 30 se retrouvent connectés électriquement à la masse, le circuit 30 peut être assimilé à une ligne en retard formée d'une self en série L1 et de deux capacités C1a et C2a connectées à chaque extrémité de la self L1 et à la masse, cette ligne à retard présente un maximum de retard à une fréquence différente de la fréquence centrale du filtre passe tout 31, créant ainsi un deuxième maximum de délai dans la courbe représentant le délai entre l'entrée et la sortie du circuit 30.

Autrement dit, le circuit 10 ou sa réalisation particulière 30 assurent la linéarité entre le déphasage dϕ et la fréquence ω sur une plage de fréquence étendue B2 incluant la plage B1.

Selon un mode de réalisation les deux fréquences d'anti-résonance f₁ et f₂ sont identiques ou quasi identiques. On entend par quasi identiques un écart entre les deux fréquences inférieur à 20% de la valeur d'une des deux fréquences. Selon un mode de réalisation l'écart entre les fréquences fa et fb est inférieur à 20% de la valeur de la fréquence la plus élevée entre fa et fb.

Selon un autre mode de réalisation, en desymétrisant les valeurs C1a et C1b par rapport à C2a et C2b, l'écart entre les fréquences f1 et f2 peut être accentué.

Selon un mode de réalisation l'écart entre la fréquence centrale f₀ du circuit passe tout et la fréquence d'antirésonance f₁ est inférieur à 30%. Selon un mode de réalisation l'écart entre f₀ et f₁ est inférieur à 30% de la valeur de la fréquence la plus élevée entre f₀ et f₁.

Aucune restriction n'existe sur les techniques de réalisation des composants de figure 3a. Par exemple, les condensateurs et les selfs peuvent être des éléments groupés ou des composants réalisés avec toute autre technique connue de l'homme du métier (composants discrets, MEMs, composants sérigraphiés, etc.)

La figure 3b montre les performances du circuit 30 avec pour valeur de composants : C1a = C2a = 27pF, C1b = C2b = 36 pF, L1 = 22 nH, C3 = 10 pF, L2 = 22 nH, C4 = C5 = 10 pF, L4 = L3 = 16 nH. Les valeurs de composants ne sont données qu'à titre illustratif et d'autres valeurs sont possibles.

La courbe A de la figure 30 représente la transmission du circuit 30 en fonction de la fréquence du signal transmis. On entend par transmission l'amplitude du signal Vout divisée par l'amplitude du signal Vin à une fréquence donnée. La transmission reste élevée sur une grande partie de la plage de fréquence d'intérêt. A 50 MHz de part et autre de la fréquence centrale du filtre passe tout, la variation de transmission par rapport à la transmission à la fréquence centrale atteint 0.03 dB

La courbe B de la figure 3b représente le délai introduit par le circuit 30 en fonction de la fréquence du signal. Le décalage temporel varie très légèrement et la variation est réduite par rapport à la même courbe représentée à la figure 2b dans le cas du circuit 20. A 50 MHz de part et autre de la fréquence centrale du filtre passe tout, la variation du délai par rapport au délai à la fréquence centrale du filtre passe tout n'atteint que 0.09 ns.

Avantageusement, le circuit 10 permet d'obtenir un décalage temporel constant ou quasi constant sur une plage de fréquence B2 étendue. Le compromis entre la stabilité en fonction de la fréquence de l'atténuation et la stabilité en fonction de la fréquence du délai est ainsi mieux équilibré.

Le circuit 10 ou l'exemple pratique de son implémentation 30 peuvent donc être utilisés dans toutes les applications pour lesquelles le même décalage temporel doit être introduit sur une large plage de fréquences.

Des exemples de telles applications sont les circuits pour l'élimination physique des interférences dans les systèmes de communication radio ou encore les amplificateurs de type feed-forward.

Selon un mode de réalisation particulier de l'invention la fréquence f₁ est égale à la fréquence f₂.

Selon un autre mode de réalisation de l'invention le filtre passe tout 1 est un circuit comprenant un circuit bouchon 21 et un circuit résonnant 22.

Un avantage de ce mode de réalisation est d'obtenir le filtre passe tout avec un circuit relativement simple à réaliser, de faible encombrement et dont les propriétés sont bien connues.

Un mode de réalisation d'un circuit passe tout est illustré à la figure 2a. Cette dernière est donnée à titre d'exemple et toute autre réalisation alternative est également possible aux fins de la présente invention.

Selon un mode de réalisation de l'invention les circuits anti-résonants sont réalisés à partir de circuit LC parallèle.

Un avantage de ce mode de réalisation est de permettre la réalisation des circuits anti-résonants de façon simple, peu coûteuse et de faibles encombrements.

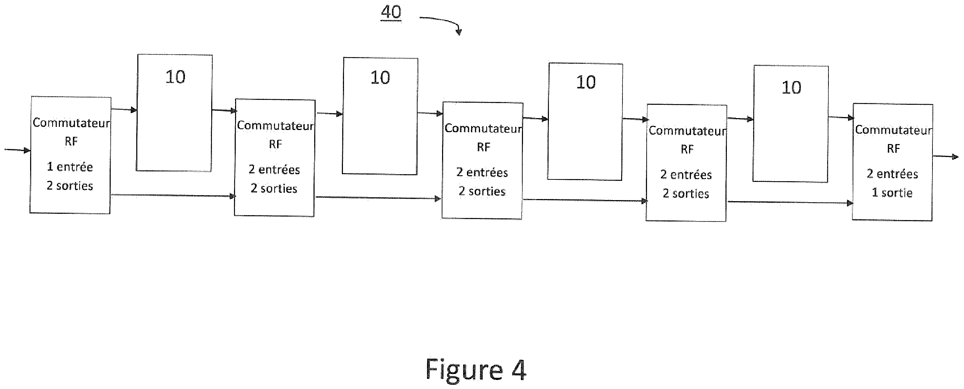

Un autre aspect de l'invention concerne une ligne à retard ou un circuit à retard paramétrable par palier 40. Un tel circuit est illustré dans la figure 4.

La ligne à retard 40 est obtenue en reliant des circuits à retard 10 en cascade. Des commutateurs RF sont disposés entre deux circuits à retard successifs. Cet agencement permet de sélectionner le nombre de circuits à retard parcourus par le signal à décaler, ce qui permet de contrôler le décalage temporel total.

Pour obtenir plus de flexibilité chacun des circuits à retard 10 insérés dans la ligne à retard peut introduire un décalage temporel qui est un multiple d'un décalage de base T_{base}. Le décalage temporel T_{base} est déterminé par les valeurs des capacités et des selfs choisies lors du design du circuit 10 ou du circuit 30.

Chacun des commutateurs RF switch a au moins deux entrées et deux sorties pour pouvoir soit envoyer le signal au circuit à retard successif soit contourner le circuit à retard successif.

Avantageusement, la ligne à retard 40 comprend aussi un composant de paramétrage du retard pour l'activation/désactivation d'un sous ensemble de commutateurs. Ce paramétrage permet de choisir exactement quel décalage temporel introduire.

Avantageusement, le premier commutateur RF switch a au moins une entrée pour prélever le signal à décaler temporellement. Le dernier commutateur RF switch possède au moins une sortie pour la transmission du signal auquel la ligne à retard applique le décalage temporel.

Grâce à la ligne à retard 40, il est possible de modifier le décalage appliqué à un signal en entrée tout en utilisant des circuits à retard ayant un retard constant ou quasi constant en fonction de la fréquence. Il est notamment avantageux d'utiliser des circuits à retard 10 ou 30 dans la ligne à retard 40.

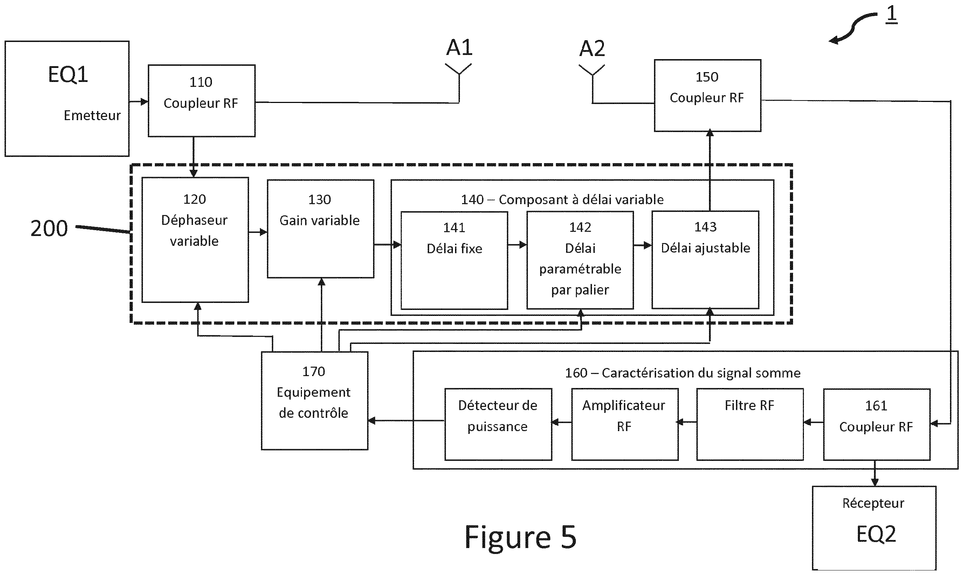

Un autre aspect de l'invention est un dispositif 1 pour l'élimination physique des interférences entre deux systèmes de communication radio, montré dans la figure 5.

Le dispositif 1 est un dispositif d'élimination d'interférences entre un premier équipement radio EQ1 comportant au moins un émetteur et un deuxième équipement radio EQ2 comportant au moins un récepteur, ledit dispositif 1 comprend:
- un premier coupleur 110 configuré pour prélever une partie du signal émis par le premier équipement radio EQ1 ;
- Un circuit de compensation 200 de la partie de signal prélevé délivrant un signal de compensation, ledit circuit de traitement 200 comportant un composant à délai variable 140 comprenant au moins un circuit à retard 10 selon l'une quelconque des revendications 1 à 5, introduisant un décalage temporel au signal prélevée.
- Un second coupleur 150 configuré pour sommer le signal de compensation au signal reçu par le deuxième équipement EQ2.

Avantageusement, le dispositif 1 permet de modifier la phase, l'amplitude et le décalage temporel du signal de compensation avant de le sommer au signal reçu par le deuxième équipement EQ2.

Avantageusement, le dispositif 1 prévoit l'utilisation du circuit à retard 10, ce qui permet d'introduire un décalage temporel constant en fonction de la fréquence.

Les équipements EQ1 et EQ2 comprennent un module radio pour la transmission/réception, un câble de connexion du module à l'antenne et un terminal de contrôle pour l'interaction avec les opérateurs.

Dans le cas d'utilisations par les forces de sécurité, les deux équipements EQ1 et EQ2 peuvent être placés dans un même véhicule. Les antennes d'émission/réception peuvent par exemple être placées sur les toits des véhicules.

Les modules radio des équipements EQ1 et EQ2 sont reliés aux antennes par de câbles qui ont une longueur comprise dans la plupart des cas entre 2 et 5 m.

La distance entre les deux antennes est dans la plupart des cas comprise entre 1 et 3 m. Un décalage temporel de l'ordre de quelques dizaines de ns existe entre le signal qui voyage directement d'une antenne à l'autre et le signal de compensation qui voyage à travers les câbles.

Ce décalage temporel est dû à la différence de distance parcourue et à la différence de vitesse de propagation des ondes radio dans différents moyens de propagation tels que l'air ou les câbles. Quand un décalage de l'ordre de quelques dizaines de ns existe, le dispositif 1 selon l'invention est particulièrement efficace dans l'élimination des interférences entre EQ1 et EQ2.

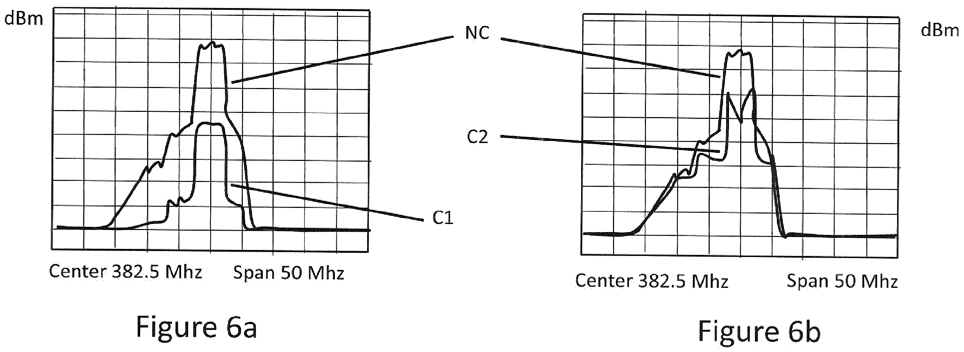

Un exemple d'élimination d'interférences entre un premier équipement radio EQ1 et un deuxième équipement radio EQ2 avec le dispositif 1 selon l'invention est montré sur la figure 6a. Dans le cas considéré un décalage de 1 ns entre le signal se propageant dans l'air et le signal se propageant dans le circuit à retard existe.

La courbe NC de figure 6a représente le signal reçu par l'équipement EQ2 sans compensation de la part du dispositif 1. La courbe C1 représente le signal obtenu au niveau de l'équipement EQ2 après compensation effectuée à l'aide du dispositif 1. Il est évident que le signal parasite reçu par EQ2 après correction est plus faible sur toute la gamme de fréquences reçues par EQ2.

Au contraire quand la compensation est effectuée à l'aide d'un dispositif comme celui décrit dans la demande de brevet US 2009/0227213 et connu de l'homme du métier, la suppression des interférences est efficace seulement sur une plage de fréquence étroite et centrée autour de la porteuse (voir creux sur la courbe C2 de la figure 6b).

La comparaison entre les figures 6a et 6b montre tout l'intérêt de l'ajustement du décalage temporel en plus de l'amplitude et de la phase du signal de compensation. La possibilité d'ajuster séparément ces trois propriétés permet d'éliminer les interférences plus efficacement par rapport aux dispositifs connus de l'homme du métier.

Les premier et deuxième équipements radio EQ1 et EQ2 peuvent utiliser des protocoles de communication de type faible débit ou haut débit.

Exemples de systèmes de communication faible débit traditionnellement utilisés par les forces de sécurité sont Tetrapol, Tetra, P25 ou autre.

Exemples de systèmes de communication haut débit sont les réseaux de communication portable de type LTE/4G.

Le dispositif selon l'invention se révèle particulièrement avantageux quand l'équipement émetteur EQ1 est un équipement de type LTE/4G. Dans ce cas l'équipement émetteur possède des canaux de communication radio large bande et l'élimination efficace des interférences sur une large plage de fréquences s'avère critique.

Selon un mode de réalisation particulier, le circuit de traitement ou circuit de compensation 200 comprend un déphaseur variable 120 modifiant la phase du signal prélevé par le premier coupleur 110 et un gain variable 130 modifiant l'amplitude du signal prélevé par le premier coupleur 110.

On entend par gain variable 130 un dispositif capable d'augmenter (gain positif) ou de diminuer (gain négatif) l'amplitude du signal à son entrée.

Un avantage de ce mode de réalisation est de pouvoir régler l'amplitude et la phase du signal de compensation pour obtenir l'élimination des interférences entre l'équipement EQ1 et l'équipement EQ2.

Selon un mode de réalisation le déphaseur 120 variable peut être réalisé avec au moins un coupleur hybride en quadrature à 3 dB associé à des diodes varicap.

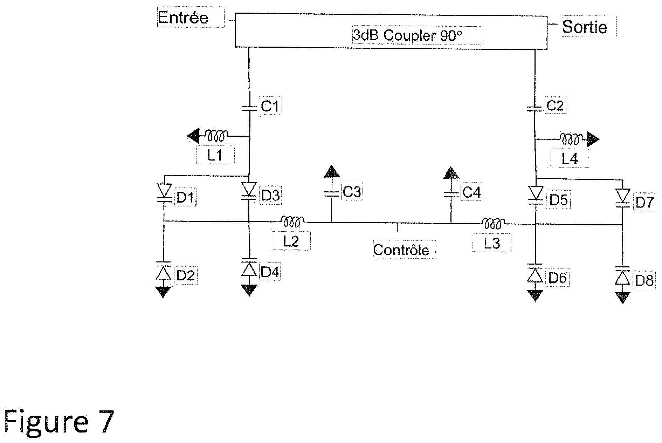

De façon connue plusieurs diodes varicap peuvent être utilisées pour améliorer la linéarité du déphaseur aux hautes puissances RF. La figure 7 montre un exemple de réalisation, D1 à D8 sont des diodes varicaps, C1 à C4 sont des capacités, L1 à L4 sont des selfs.

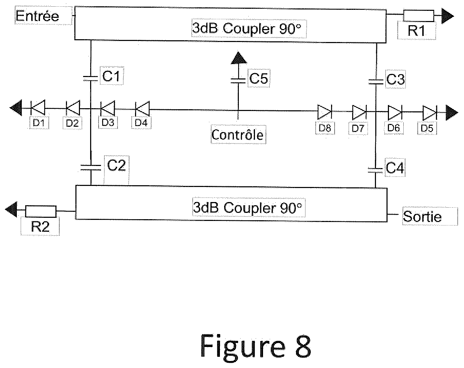

Selon un mode de réalisation, le gain variable peut être réalisé avec au moins un coupleur hybride en quadrature à 3 dB associé à des diodes PIN. La figure 8 montre un exemple de réalisation, D1 à D8 sont des diodes PIN, C1 à C5 sont des capacités, R1 et R2 sont des résistances.

Selon un mode de réalisation, particulier le dispositif 1 comprend un composant à délai variable 140 comportant :
- un premier circuit 141 comportant au moins un circuit à retard introduisant un délai fixe 141 ;
- un second circuit 142 agencé en série du premier circuit 141 comportant au moins une ligne à retard selon la revendication 5 introduisant un premier délai paramétrable par palier et ;
- un troisième circuit 143 agencé en série des premier et second circuits 141, 142 introduisant un second délai paramétrable de façon continu.

Avantageusement, le composant 140 permet de régler le décalage temporel introduit par le dispositif 1.

Avantageusement, le circuit à retard 10 selon l'invention peut être utilisé à l'intérieur des circuits 141 et 142 pour introduire un décalage temporel fixe sur une large plage de fréquences.

Le circuit 142 introduisant un premier délai paramétrable par palier peut être réalisé avec la ligne à retard 40 de la figure 5.

Le circuit 143 introduisant un deuxième délai paramétrable peut être réalisé avec une inductance associé à des diodes varicap.

Selon un mode de réalisation, le dispositif 1 comprend :
- Un coupleur 161 configuré pour prélever une partie du signal somme et transmettre le reste du signal somme au deuxième équipement EQ2 ;
- Un équipement 160 de caractérisation du signal somme ;
- Un équipement de contrôle 170 configuré pour recevoir le signal issu de l'équipement 160 de caractérisation du signal somme et pour contrôler les équipements de modification des propriétés du signal prélevée 120, 130,140.

On entend par signal somme la combinaison du signal de compensation issu du circuit de traitement 200 et du signal reçu par le deuxième équipement EQ2.

Selon un mode de réalisation le dispositif 160 est un équipement de mesure de puissance de la porteuse du signal somme.

Avantageusement, l'équipement de caractérisation du signal somme 160 permet d'évaluer le signal résiduel après soustraction du signal de compensation. Idéalement, le signal somme obtenu comme combinaison du signal de compensation et du signal reçu au niveau de l'équipement EQ2 est nul si les interférences sont parfaitement éliminées.

L'équipement de caractérisation du signal somme 160 comprend au moins un des éléments suivants : un coupleur 161, un filtre RF et un détecteur de puissance. Selon un mode de réalisation l'équipement 160 peut comprendre également un amplificateur RF.

La présence d'un filtre RF et d'un amplificateur RF permet de mesurer de façon plus fiable la puissance associée au signal somme dans la bande de fréquence d'émission de l'équipement EQ1.

L'équipement 160 a donc le rôle de mesurer les interférences résiduelles dans le signal somme obtenu comme combinaison du signal de compensation et du signal reçu par l'équipement EQ2 et directement émis par EQ1.

Le signal issu de l'équipement 160 est envoyé à un équipement de contrôle 170. Sur la base du signal reçu, l'équipement 170 modifie les paramètres du circuit de compensation pour minimiser le signal somme.

L'équipement de contrôle 170 comporte par exemple une mémoire électronique pour enregistrer les caractéristiques du déphaseur variable 120, du gain variable 130, du composant à délai 140. Les caractéristiques du composant à délai 140 sont par exemple les caractéristiques du délai fixe 141, du délai paramétrable par palier 142 et du délai paramétrable 143.

L'équipement de contrôle modifie le déphasage, l'atténuation et le décalage temporel du signal de compensation pour minimiser la puissance du signal somme mesurée par l'équipement 160. La minimisation de la puissance mesurée par l'équipement 160 est donc le critère utilisé pour minimiser les interférences entre un premier équipement EQ1 et un deuxième équipement EQ2.

Selon un mode de réalisation, le premier équipement EQ1 et le deuxième équipement EQ2 sont le même équipement.

A cause de la superposition des gammes fréquentielles d'émission et réception l'utilisation du dispositif 1 selon l'invention s'avère particulièrement avantageux quand l'équipement EQ1 et l'équipement EQ2 sont le même équipement.

Selon un mode de réalisation le premier équipement EQ1 et le deuxième équipement EQ2 utilisent la même antenne.

Le système d'élimination des interférences selon l'invention s'avère particulièrement avantageux quand les deux équipements EQ1 et EQ2 utilisent la même antenne.

Selon un mode de réalisation, le composant à délai variable 140 est placé sur la connexion électrique reliant le premier équipement EQ1 à une antenne A1.

Selon un mode de réalisation, le composant à délai variable 140 est placé sur la connexion électrique reliant le deuxième équipement EQ2 à une antenne A2.

Avantageusement, le placement du composant à délai variable 140 entre un équipement et l'antenne auquel il est relié permet d'introduire un retard sur le chemin antenne. Cela s'avère particulièrement utile quand le chemin antenne est parcouru plus rapidement que le circuit de compensation 200. Par exemple, ce placement du composant à délai variable 140 est particulièrement avantageux quand les deux équipements EQ1 et EQ2 utilisent la même antenne.

## Revendications

1. Circuit à retard (10) pour le décalage temporel d'un signal radiofréquence d'entrée (Vin), ledit circuit à retard (10) comprenant un filtre passe tout (1) ayant une fréquence centrale donnée (f₀) configuré pour linéariser le déphasage du signal de sortie (Vout) par rapport au signal d'entrée (Vin) en fonction de la fréquence sur une première gamme fréquentielle (B1) et **caractérisé en ce qu'**il comprend un premier circuit anti-résonant (2) ayant une première fréquence centrale (f₁) et un deuxième circuit anti-résonant (3) ayant une deuxième fréquence centrale (f₂), le filtre passe tout (1) et les deux circuits anti-résonants (2, 3) étant configurés et agencés pour linéariser le déphasage du signal en sortie (Vout) par rapport au signal d'entrée (Vin) en fonction de la fréquence sur une seconde gamme fréquentielle (B2) incluant la première gamme (B1), l'écart entre la première (f₁) et la deuxième (f₂) fréquence centrale étant inférieure à 30% de la valeur d'une des deux fréquences centrales (f₁, f₂), l'écart entre la première fréquence centrale (f₁) et la fréquence centrale donnée (f₀) du circuit passe tout (1) étant inférieur à 30% de la valeur de la fréquence la plus élevée entre la première fréquence centrale (f₁) et la fréquence centrale donnée (f₀)».

2. Circuit à retard (10) selon la revendication précédente **caractérisé en ce que** le filtre passe tout (1) est un circuit comprenant au moins un circuit bouchon formé par une première inductance (L1) associée en parallèle avec un premier condensateur (C1a), un deuxième condensateur (C2a), un troisième condensateur (C3a) et un quatrième condensateur (C4a), ledit circuit bouchon possédant une fréquence de coupure fa, le filtre passe tout (1) comprenant en outre un circuit résonnant formé par un cinquième condensateur (C3) associé en série avec une deuxième inductance (L2), ledit circuit résonnant possédant une fréquence de résonnance fb, les fréquence de coupure fa et la fréquence de résonnance fb ayant un écart inférieur à 20% de la valeur de l'une des deux fréquences.

3. Circuit à retard (10) selon l'une des revendications précédentes, **caractérisé en ce que** chacun des circuits anti-résonnants (2,3) est formé par une capacité associée en parallèle avec une inductance.

4. Ligne à retard (40) pour l'introduction d'un retard variable dans un signal de sortie (Vout), **caractérisée en ce qu'**elle comprend un montage en cascade d'une pluralité de circuits à retard (10) selon l'une quelconque des revendications 1 à 3, chaque circuit à retard (10) :
• introduisant un multiple donné d'un retard de base (T_{base}) et ;
• étant associé à un commutateur (commutateur RF) pour activer ou désactiver le circuit à retard,
un composant de paramétrage du retard étant configuré pour introduire un retard donné par activation/désactivation d'un sous ensemble des commutateurs de la ligne à retard.

5. Dispositif (1) de réduction d'interférences entre un premier équipement radio (EQ1) comportant au moins un émetteur et un deuxième équipement radio (EQ2) comportant au moins un récepteur, **caractérisé en ce que** ledit dispositif comprend :
• Un premier coupleur (110) configuré pour prélever une partie du signal émis par le premier équipement radio (EQ1) ;
• Un circuit de traitement (200) de la partie de signal prélevé délivrant un signal modifié, ledit circuit de traitement (200) comportant un composant à délai variable (140) comprenant au moins un circuit à retard (10) selon l'une quelconque des revendications 1 à 3, introduisant un décalage temporel au signal prélevée ;
• Un second coupleur (150) configuré pour sommer le signal modifié au signal reçu par le deuxième équipement (EQ2), ledit signal étant nommé signal somme.

6. Dispositif (1) selon la revendication 5, **caractérisé en ce que** le circuit de traitement (200) comprend un déphaseur variable (120) modifiant la phase du signal prélevé par le premier coupleur (110) et un gain variable (130) modifiant l'amplitude du signal prélevé par le premier coupleur (110).

7. Dispositif (1) d'élimination d'interférences selon la revendication 5, **caractérisé en ce qu'**il comprend un composant à délai variable (140) comportant :
• un premier circuit (141) comportant au moins un circuit à retard selon l'une quelconque des revendications 1 à 3 introduisant un délai fixe (141) ;
• un second circuit (142) agencé en série du premier circuit (141) comportant au moins une ligne à retard selon la revendication 4 introduisant un premier délai paramétrable par palier et ;
• un troisième circuit (143) agencé en série des premier et second circuits (141, 142) introduisant un second délai paramétrable.

8. Dispositif (1) selon l'une quelconque des revendications 5 à 7, **caractérisé en ce qu'**il comprend :
• Un coupleur (161) configuré pour prélever une partie du signal somme et transmettre le reste du signal somme au deuxième équipement (EQ2) ;
• Un équipement (160) de caractérisation du signal somme ;
• Un équipement de contrôle (170) configuré pour recevoir le signal issu de l'équipement (160) de caractérisation du signal somme et pour contrôler les équipements de modification des propriétés du signal prélevée (120, 130,140).

9. Dispositif (1) selon l'une quelconque des revendications 5 à 8 **caractérisé en ce que** le premier équipement radio (EQ1) et le deuxième équipement radio (EQ2) sont le même équipement.

10. Dispositif (1) selon l'une quelconque des revendications 5 à 9 **caractérisé en ce que** le premier équipement radio (EQ1) et le deuxième équipement radio (EQ2) utilisent la même antenne.

11. Dispositif (1) selon l'une quelconque des revendications 5 à 10 **caractérisé en ce que** les coupleurs (110,150) sont des coupleurs radiofréquence ou des diviseurs de puissance asymétrique.

12. Dispositif (1) selon l'une quelconque des revendications 5 à 10 **caractérisé en ce que** l'équipement de contrôle (170) contient une mémoire pour l'enregistrement des paramètres du déphaseur (120), du gain variable (130) et du délai (140).

13. Dispositif (1) selon la revendication 5 **caractérisé en ce que** le composant à délai variable (140) est placé sur la connexion électrique reliant le premier équipement EQ1 à une antenne A1.

14. Dispositif (1) selon la revendication 5 **caractérisé en ce que** le composant à délai variable (140) est placé sur la connexion électrique reliant le deuxième équipement EQ2 à une antenne A2.

## Patentansprüche

1. Verzögerungsschaltung (10) für die zeitliche Verzögerung eines Eingangs-Funkfrequenzsignals (Vin), wobei die genannte Verzögerungsschaltung (10) einen Allpassfilter (1) umfasst, der eine bestimmte zentrale Frequenz (f₀) aufweist und konfiguriert ist, um die Phasenänderung des Ausgangssignals (Vout) in Bezug auf das Eingangssignal (Vin) in Abhängigkeit von der Frequenz über einen ersten Frequenzbereich (B1) zu linearisieren und **dadurch gekennzeichnet ist, dass** sie eine erste Anti-Resonanzschaltung (2) mit einer ersten zentralen Frequenz (f₁) und eine zweite Anti-Resonanzschaltung (3) mit einer zweiten zentralen Frequenz (f₂) umfasst, wobei der Allpassfilter (1) und die zwei Anti-Resonanzschaltungen (2, 3) ausgestaltet und angeordnet sind, um die Phasenänderung des Signals am Ausgang (Vout) in Bezug auf das Eingangssignal (Vin) in Abhängigkeit von der Frequenz über einen zweiten Frequenzbereich (B2) zu linearisieren, der den ersten Bereich (B1) enthält, wobei die Abweichung zwischen der ersten (f₁) und der zweiten (f₂) zentralen Frequenz unter 30 % des Wertes einer der zwei zentralen Frequenzen (f₁, f₂) beträgt, wobei die Abweichung zwischen der ersten zentralen Frequenz (f1) und der bestimmten zentralen Frequenz (f₀) der Allpass-Schaltung (1) unter 30 % des Wertes der höchsten Frequenz zwischen der ersten zentralen Frequenz (f₁) und der bestimmten zentralen Frequenz (f₀) ist.

2. Verzögerungsschaltung (10) gemäß dem voranstehenden Anspruch, **dadurch gekennzeichnet, dass** dieser Allpassfilter (1) eine Schaltung ist, umfassend wenigstens einen Sperrkreis, der durch eine erste Induktanz (L1) geformt ist, die parallel einem ersten Kondensator (C1a), einem zweiten Kondensator (C2a), einem dritten Kondensator (C3a) und einem vierten Kondensator (C4a) zugeordnet ist, wobei der genannte Sperrkreis eine Grenzfrequenz fa besitzt, wobei der Allpassfilter (1) darüber hinaus eine Resonanzschaltung umfasst, die durch einen fünften Kondensator (C3) geformt ist, der in Serie einer zweiten Induktanz (L2) zugeordnet ist, wobei die genannte Resonanzschaltung eine Resonanzfrequenz fb besitzt, wobei die Grenzfrequenz fa und die Resonanzfrequenz fb eine Abweichung von unter 20 % des Wertes einer der zwei Frequenzen aufweist.

3. Verzögerungsschaltung (10) gemäß einem der voranstehenden Ansprüche, **dadurch gekennzeichnet, dass** jede Anti-Resonanzschaltung (2, 3) durch eine parallel einer Induktanz zugeordnete Kapazität gebildet ist.

4. Verzögerungsleitung (40) zum Einführen einer variablen Verzögerung in einem Ausgangssignal (Vout), **dadurch gekennzeichnet, dass** sie eine Kaskadenmontage einer Vielzahl von Verzögerungsschaltungen (10) gemäß irgendeinem der Ansprüche 1 bis 3 umfasst, wobei jede Verzögerungsschaltung (10):
• ein bestimmtes Vielfaches einer Basisverzögerung (T_{base}) einführt und;
• einem Schalter (Schalter RF) zum Aktivieren oder Deaktivieren der Verzögerungsschaltung zugeordnet ist.
wobei ein Parametrierungsbauteil der Verzögerung zum Einführen einer bestimmten Verzögerung per Aktivierung / Deaktivierung einer Teilgruppe der Schalter der Verzögerungsleitung ausgestaltet ist.

5. Vorrichtung (1) zur Frequenzminderung zwischen einer ersten Funkausrüstung (EQ1), umfassend wenigstens einen Sender und eine zweite Funkausrüstung (EQ2), umfassend wenigstens einen Empfänger, **dadurch gekennzeichnet, dass** die genannte Vorrichtung umfasst:
• einen ersten Koppler (110), der zum Entnehmen eines Teils des Signals ausgestaltet ist, das von der ersten Funkausrüstung (EQ1) ausgegeben ist;
• eine Verarbeitungsschaltung (200) des Teils des entnommenen Signals, das ein geändertes Signal ausgibt, wobei die Verarbeitungsschaltung (200) ein Bauteil mit variablem Aufschub (140) umfasst, umfassend wenigstens eine Verzögerungsschaltung (10) gemäß irgendeinem der Ansprüche 1 bis 3, die eine zeitliche Verschiebung in das entnommene Signal einführt;
• einen zweiten Koppler (150), der zum Summieren des geänderten Signals zu dem Signal ausgestaltet ist, das von der zweiten Ausrüstung (EQ2) empfangen ist, wobei das genannte Signal als Summensignal bezeichnet ist.

6. Vorrichtung (1) gemäß Anspruch 5, **dadurch gekennzeichnet, dass** die Verarbeitungsschaltung (200) einen variablen Phasenverschieber (120) umfasst, der die Phase des von dem ersten Koppler (110) entnommenen Signals ändert und eine variable Verstärkung (130), die die Amplitude des von dem ersten Koppler (110) entnommenen Signals ändert.

7. Vorrichtung (1) zur Ausschaltung von Interferenzen gemäß Anspruch 5, **dadurch gekennzeichnet, dass** sie ein Bauteil mit variablem Aufschub (140) umfasst, umfassend:
• eine erste Schaltung (141), umfassend wenigstens eine Verzögerungsschaltung gemäß irgendeinem der Ansprüche 1 bis 4, die einen festen Aufschub (141) einführen;
• eine zweite Schaltung (142), die in Serie der ersten Schaltung (141) angeordnet ist, umfassend wenigstens eine Verzögerungsleitung gemäß Anspruch 5, die einen ersten parametrierbaren Aufschub pro Ebene einführt; und
• eine dritte Schaltung (143), die in Serie der ersten und der zweiten Schaltung (141, 142) angeordnet ist, die einen zweiten parametrierbaren Aufschub einführen.

8. Vorrichtung (1) gemäß irgendeinem der Ansprüche 5 bis 7, **dadurch gekennzeichnet, dass** sie umfasst:
• einen Koppler (161), der zum Entnehmen eines Teils des Summensignals und zum Übertragen des Restes des Summensignals auf die zweite Ausrüstung (EQ2) ausgestaltet ist;
• eine Ausrüstung (160) zum Kennzeichnen des Summensignals;
• eine Steuerausrüstung (170), die zum Empfangen des Signals, das aus der Ausrüstung (160) zum Kennzeichnen des Summensignals stammt, und zum Kontrollieren der Änderungsausrüstungen der Eigenschaften des entnommenen Signals (120, 130, 140) ausgestaltet ist.

9. Vorrichtung (1) gemäß irgendeinem der Ansprüche 5 bis 8, **dadurch gekennzeichnet, dass** die erste Funkausrüstung (EQ1) und die zweite Funkausrüstung (EQ2) dieselbe Ausrüstung sind.

10. Vorrichtung (1) gemäß irgendeinem der Ansprüche 5 bis 9, **dadurch gekennzeichnet, dass** die erste Funkausrüstung (EQ1) und die zweite Funkausrüstung (EQ2) dieselbe Antenne verwenden.

11. Vorrichtung (1) gemäß irgendeinem der Ansprüche 5 bis 10, **dadurch gekennzeichnet, dass** die Koppler (110, 150) Funkfrequenzkoppler oder asymmetrische Leistungsteiler sind.

12. Vorrichtung (1) gemäß irgendeinem der Ansprüche 5 bis 10, **dadurch gekennzeichnet, dass** die Kontrollausrüstung (170) einen Speicher zum Speichern der Parameter des Phasenverschiebers (120), der variablen Verstärkung (130) und des Aufschubs (140) enthält.

13. Vorrichtung (1) gemäß Anspruch 5, **dadurch gekennzeichnet, dass** das Bauteil mit variablem Aufschub (140) auf dem elektrischen Anschluss angeordnet ist, der die ersten Ausrüstung EQ1 mit einer Antenne A1 verbindet.

14. Vorrichtung (1) gemäß Anspruch 5, **dadurch gekennzeichnet, dass** das Bauteil mit variablem Aufschub (140) auf dem elektrischen Anschluss angeordnet ist, der die zweite Ausrüstung EQ2 mit einer Antenne A2 verbindet.

## Claims

1. A delay circuit (10) for time offsetting an input radiofrequency signal (Vin), said delay circuit (10) comprising an all-pass filter (1) having a given central frequency (f₀) configured to linearize the phase-shift of the output signal (Vout) relative to the input signal (Vin) as a function of the frequency on a first frequency range (B1) and **characterised in that** it comprises a first antiresonant circuit (2) having a first central frequency (f₁) and a second antiresonant circuit (3) having a second central frequency (f₂), the all-pass filter (1) and the two antiresonant circuits (2, 3) being configured and arranged to linearize the phase-shift of the output signal (Vout) relative to the input signal (Vin) as a function of the frequency on a second frequency range (B2) including the first range (B1), the difference between the first (f₁) and the second central frequency (f₂) being inferior to 30% of the value of the highest frequency between the first central frequency (f₁) and the given central frequency (f₀).

2. Delay circuit (10) according to the preceding claim, **characterised in that** the all-pass filter (1) is a circuit comprising at least one stopper circuit formed by a first inductor (L1) associated in parallel with a first capacitor (C1a), a second capacitor (C2a), a third capacitor (C3a) and a fourth capacitor (C4a), said stopper circuit having a cut-off frequency fa, the all-pass filter (1) further comprising a resonant circuit formed by a fifth capacitor (C3) associated in series with a second inductor (L2), said resonating circuit having a resonance frequency fb, the cut-off frequency fa and resonance frequency fb differing by less than 20% of the value of one of both frequencies.

3. Delay circuit (10) according to one of the preceding claims, **characterised in that** each of the antiresonant circuits (2, 3) is formed by a capacitance associated in parallel with an inductor.

4. Delay line (40) for introducing a variable delay in an output signal (Vout), **characterised in that** it comprises a cascading of a plurality of delay circuits (10) according to any of claims 1 to 3, each delay circuit (10):
• introducing a given multiple of a base delay (T_{base}); and
• being associated with a switch (RF switch) to activate or deactivate the delay circuit,
a delay parameterising component being configured to introduce a given delay by activating/deactivating a sub-assembly of the switches of the delay line.

5. Device (1) for reducing interference between a first piece of radio equipment (EQ1) comprising at least one transmitter and a second piece of radio equipment (EQ2) comprising at least one receiver, **characterised in that** said device comprises:
• a first coupler (110) configured to sample a part of the signal transmitted by the first piece of radio equipment (EQ1);
• a processing circuit (200) for processing the sampled signal part delivering a modified signal, said processing circuit (200) comprising a variable delay component (140) comprising at least one delay circuit (10) according to any of claims 1 to 3, introducing a time offset to the sampled signal;
• a second coupler (150) configured to sum the modified signal to the signal received by the second piece of equipment (EQ2), said signal being called a sum signal.

6. Device (1) according to claim 5, **characterised in that** the processing circuit (200) comprises a variable phase-shifter (120) modifying the phase of the signal sampled by the first coupler (110) and a variable gain (130) modifying the amplitude of the signal sampled by the first coupler (110).

7. Interference removing device (1) according to claim 5, **characterised in that** it comprises a variable delay component (140) comprising:
• a first circuit (141) comprising at least one delay circuit according to any of claims 1 to 3 introducing a fixed delay (141);
• a second circuit (142) arranged in series with the first circuit (141) comprising at least one delay line according to claim 4 introducing a first stepped parameterisable delay; and
• a third circuit (143) arranged in series with the first and second circuits (141, 142) introducing a second parameterisable delay.

8. Device (1) according to any of claims 5 to 7, **characterised in that** it comprises:
• a coupler (161) configured to sample a part of the sum signal and transmit the rest of the sum signal to the second piece of equipment (EQ2);
• a piece of equipment (160) for characterising the sum signal;
• a piece of control equipment (170) configured to receive the signal from the piece of equipment (160) for characterising the sum signal and to control the pieces of equipment for modifying the properties of the sampled signal (120, 130, 140).

9. Device (1) according to any of claims 5 to 8, **characterised in that** the first piece of radio equipment (EQ1) and the second piece of radio equipment (EQ2) are the same piece of equipment.

10. Device (1) according to any of claims 5 to 9, **characterised in that** the first piece of radio equipment (EQ1) and the second piece of radio equipment (EQ2) use the same antenna.

11. Device (1) according to any of claims 5 to 10, **characterised in that** the couplers (110, 150) are radiofrequency couplers or asymmetric power dividers.

12. Device (1) according to any of claims 5 to 10, **characterised in that** the piece of control equipment (170) contains a memory for recording the parameters of the phase-shifter (120), the variable gain (130) and the delay (140).

13. Device (1) according to claim 5, **characterised in that** the variable delay component (140) is placed on the electrical connection connecting the first piece of equipment EQ1 to an antenna A1.

14. The device (1) according to claim 5, **characterised in that** the variable delay component (140) is placed on the electrical connection connecting the second piece of equipment EQ2 to an antenna A2.
